# EUROPEAN PATENT APPLICATION

(11) **EP 1 879 227 A1**
(43) Date of publication of application: **16.01.2008**
(21) Application number: 07013920.9
(22) Date of filing: 16.07.2007
(51) Int. Cl.: H01L 23/498, H01L 23/538, H05K 3/46

(54) **Multilayer wiring substrate and manufacturing method thereof**

(30) Priority: 14.07.2006 JP 2006194753
(71) Applicant: SHINKO ELECTRIC INDUSTRIES CO., LTD., Nagano-shi, Nagano 381-2287 (JP)
(72) Inventor: Sunohara, Masahiro, Nagano-shi Nagano 381-2287 (JP)
(74) Representative: Zimmermann, Gerd Heinrich

(57) **Abstract**

A multilayer wiring substrate has a plurality of wiring layers (13a-13e; 35, 43, 49, 55, 65) and interlayer insulating films (15ab-15de; 37, 45, 51, 57), as well as a via of a type which connects between adjacent wiring layers and a via (17', 63) of a type which connects upper and lower wiring layers through two or more interlayer insulating films, wherein at least some of the interlayer insulating films (15ab-15de; 37, 45, 51, 57) are formed of inorganic insulating films, and the via of the type, which connects upper and lower wiring layers through two or more interlayer insulating films, is formed as a single via which penetrates through the interlayer insulating films all of which are formed of the inorganic insulating films. Preferably, all of the insulating films are formed of the inorganic insulating films, and the inorganic insulating films are formed by a low-temperature CVD method. The thickness of the inorganic insulating films is preferably between 0.5 and 2.0µm.

## Description

This application claims priority to Japanese Patent Application No. 2006-194753, filed July 14, 2006, in the Japanese Patent Office. The priority application is incorporated by reference in its entirety.

Generally, the present disclosure relates to multilayer wiring substrates. The present disclosure relates to a multilayer wiring substrate manufactured by a build-up method. The multilayer wiring substrate is applicable for the fabrication of a package having semiconductor devices mounted thereon, or applicable as an interposer used for mounting semiconductor devices or the like on a circuit substrate etc.

A built-up multilayer wiring substrate is fabricated through steps of; forming a wiring layer by a semi-additive method after a via hole is formed in an insulating film on a core substrate, and repeating the formation of insulating films and wiring layers in order to form a multilayer wiring substrate comprising a necessary number of wiring layers. The insulating films are formed by a build-up resin, which is typically an epoxy resin, and the via holes are typically formed by laser processing since the build-up resin contains a filler.

Fig. 6 diagrammatically shows a related-art built-up multilayer wiring substrate fabricated by such a method. The built-up multilayer wiring substrate in this drawing has five wiring layers 103a, 103b, 103c, 103d, 103e formed on a core substrate 101 made of i.e. glass-cloth-reinforced epoxy resin, and interlayer insulating films 105ab, 105bc, 105cd, 105de located between adjacent wiring layers. While vias 107 connecting between adjacent wiring layers are formed in the respective insulating films, a via 107' connecting upper and lower wiring layers (in Fig. 6, they are the top-most and bottom-most wiring layers 103e, 103a) through two or more insulating films is also formed. The via 107' of the latter type is known as a "stack via" which is employed in order to reduce the route length of wiring. The stack via 107' has a structure in which vias 107'a, 107'b, 107'c, 107'd formed individually within the respective insulating films 105ab, 105bc, 105cd, 105de are connected by lands 109. Typically, the vias 107 and the stack via 107' comprising the vias 107'a, 107'b, 107'c, 107'd in the respective insulating films are both formed by filling a wiring material within the openings formed through laser processes in the respective insulating films made of a resin. Over the top-most wiring layer 103e, a protective layer 111 is formed using a solder resist, and within openings thereof, pads 113 used for mounting semiconductor devices (not shown) or the like are provided. On the other side of the core substrate 101 shown in Fig. 6, solder bumps connected to the through holes 115 of the core substrate 101 may be provided, or another build-up structure similar to the one shown may be formed.

It is also known that insulating films of a built-up multilayer wiring substrate can be made by an inorganic material such as SiO₂ instead of a resin. For example, Japanese Patent Unexamined Publication No. 1-257397 describes a substrate of a multilayer wiring structure in which, over an insulating substrate including an SiO₂ insulating film deposited on an aluminum substrate through vapor deposition, alternating wiring layers and insulating films are formed, the insulating films being formed of SiO₂ through vapor deposition to a film thickness of 10µm, and having via holes formed therein by etching. Each of the via holes is formed every time each of the insulating films is formed.

In the built-up multilayer wiring substrate such as the one shown in Fig. 6, the thermal stress, promoted by the use of heterogeneous materials having different thermal expansion coefficients, tends to concentrate to the roots of the vias 107'a, 107'b, 107'c, 107'd in the respective insulating films, which constitute the stack via 107', and there is a risk of having broken wiring in those portions. The thermal stress grows as the vias' diameter and the depth (thickness of the insulating films) become larger. An insulating film formed of the present build-up resin needs a thickness of at least 30µm or so, in the light of its insulation characteristic and workability. Furthermore, the minimum diameter of an opening provided by a laser process within an insulating film made of resin is approximately from 30µm to 40µm. These facts present the hindrance against avoiding broken wiring in stack vias, and against achieving highly dense wirings and vias within the current built-up multilayer wiring substrates.

Furthermore, since the stack via 107' of a related-art built-up multilayer wiring substrate is formed by connecting individual vias 107'a, 107'b, 107'c, 107'd in the plurality of insulating films, there is a potential problem of a connection failure depending on the degree of accuracy in forming those individual vias.

In light of the above, the multilayer wiring substrate according to independent claim 1 and the manufacturing method of a multilayer wiring substrate according to independent claim 5 are provided.
Further advantages, features, aspects and details of the disclosure are evident from the dependent claims, the description and the drawings.
Exemplary embodiments of the present invention provide a multilayer wiring substrate which has highly reliable vias even if they pass through two or more insulating films, and allows highly dense wirings and vias.

A multilayer wiring substrate of one or more embodiments of the present invention comprises a plurality of wiring layers and interlayer insulating films, and a via of a type which connects between upper and lower wiring layers through two or more interlayer insulating films, wherein at least some of the interlayer insulating films are formed of inorganic insulating films and the via of the type which connects upper and lower wiring layers through two or more interlayer insulating films is formed as a single via which penetrates through interlayer insulating films all of which are formed of inorganic insulating films.

Preferably, all the interlayer insulating films are formed of inorganic insulating films.
Preferably, the inorganic insulating films are formed by a low-temperature CVD method.
Preferably, the thickness of the inorganic insulating films is from 0.5 to 2.0µm, more preferably from 0.5 to 1.5µm, and most preferably from 0.5 to 1.0µm.

The multilayer wiring substrate of one or more embodiments of the present invention may be manufactured by a method comprising forming two or more inorganic insulating films, forming an opening at once in the two or more inorganic insulating films by photolithographic method, and forming a via of the type which connects between upper and lower wiring layers through the two or more interlayer insulating films by using the opening.

One or more embodiments of the present invention may include one or more the following advantages. For example, the use of the inorganic insulating films having a superior withstand voltage allows the thinner interlayer insulating films, so that the depths of the vias connecting wirings on the various layers may be made extremely smaller, including the via of the type which connects upper and lower wiring layers through two or more interlayer insulating films. This will realize the minimization of the thermal stress imposed on the vias, and especially, the risk of having a connection failure is minimized, which is caused by a broken wiring within the via of the type which connects upper and lower wiring layers through two or more interlayer insulating films, thus, a highly reliable multilayer wiring substrate may be provided. At the same time, highly dense wirings and vias may be realized, which have never been possible in those multilayer wiring substrates fabricated by using related-art build-up resins.

One or more embodiments of the present invention is also applicable to those substrates which use materials having low thermal tolerances since the inorganic insulating films are formed through a low-temperature CVD method, thus it is superior in general versatility.
One or more embodiments provide a multilayer wiring substrate has a plurality of wiring layers and interlayer insulating films, as well as a via of a type which connects between adjacent wiring layers and a via of a type which connects upper and lower wiring layers through two or more interlayer insulating films, wherein at least some of the interlayer insulating films are formed of inorganic insulating films, and the via of the type, which connects upper and lower wiring layers through two or more interlayer insulating films, is formed as a single via which penetrates through the interlayer insulating films all of which are formed of the inorganic insulating films.
Embodiments are also directed to apparatuses manufactured by the disclosed methods and including apparatus parts correlating with described method steps. Furthermore, embodiments according to the invention are also directed to methods by which the described apparatus is manufactured. It may include method steps manufacturing parts of the apparatus. The method steps may be performed by way of hardware components, firmware, a computer programmed by appropriate software, by any combination thereof or in any other manner.
Other features and advantages may be apparent from the following detailed description, the accompanying drawings and the claims.

Fig. 1 is a diagrammatic view explaining a multilayer wiring substrate according to an exemplary embodiment of the present invention;
Figs. 2A to 2D show a series of views explaining diagrammatically the first half of the manufacturing processes of the multilayer wiring substrate according to an exemplary embodiment of the present invention;
Figs. 3A to 3C show a series of views explaining diagrammatically the second half of the manufacturing processes of the multilayer wiring substrate according to the exemplary embodiment of the present invention;
Fig. 4 is a diagrammatic view explaining one exemplary embodiment of the multilayer wiring substrate of the present invention;
Fig. 5 is a diagrammatic view explaining another exemplary embodiment of the multilayer wiring substrate of the present invention; and
Fig. 6 is a view explaining a related-art multilayer wiring substrate.

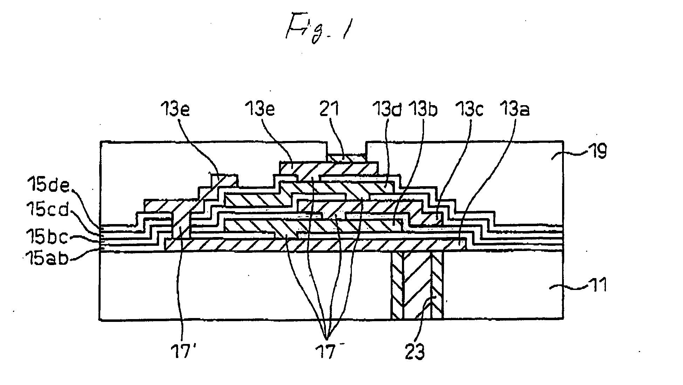

Fig. 1 shows a partial diagrammatic view of a multilayer wiring substrate according to an exemplary embodiment of the present invention. The multilayer wiring substrate in this figure comprises five wiring layers 13a, 13b, 13c, 13d, 13e formed over a core substrate 11, and between adjacent ones of the wiring layers, interlayer insulating films 15ab, 15bc, 15cd, 15de are provided. Vias 17 of a type which connect between adjacent wiring layers are formed in the respective interlayer insulating films while a via 17' of a type which connects upper and lower wiring layers (in Fig. 1, they are the top-most and bottom-most wiring layers 13e and 13a) through two or more insulating films is formed. The via 17', as explained below, is formed at once by filling a wiring material within an opening which penetrates through two or more interlayer insulating films which are interposed between the upper and lower wirings to be connected. Accordingly, the via 17' differs from the related-art via 107' previously explained with reference to Fig. 6, in that, it does not require the processes to connect the individual vias 107'a, 107'b, 107'c, 107'd, 107'e (Fig. 6), the number of which is equal of that of the interlayer insulating films, or the presence of the lands 109 (Fig. 6) that have been necessary for the connecting processes. Over the top-most wiring layer 13e, a protective layer 19 is formed by a solder resist, and within the openings thereof, a pad 21 is provided for mounting a semiconductor device (not shown) or the like. Over the other side of the core substrate 11 shown in Fig. 1, there may be a solder pump (not shown) connecting to a through hole 23 of the core substrate, or another built-up multilayer wiring structure similar to the one shown may be provided.

As for the core substrate 11 of the multilayer wiring substrate, a resin substrate such as one made of a glass-cloth-reinforced epoxy resin or a silicon substrate etc. may be used. In the case of a silicon substrate having an electrical conductivity, it is used after insulating treatment is provided on the surface thereof.

The wiring layers 13a-13e and the two types of vias 17, 17' may be formed by using a typical wiring material such as Cu through a method generally used for the formation of multilayer wirings. The thickness of the wiring layers may be as small as i.e. 0.5 to 1µm when the wiring layers are formed by sputtering or vapor deposition, and when a thick film is further formed thereon through a plating method, it may be i.e. 4 to 10µm.

In the exemplary embodiment of the present invention, as for the material for the interlayer insulating films 15ab, 15bc, 15cd, 15de, an inorganic material is used. The interlayer insulating film of the inorganic material is preferably formed through a low-temperature plasma CVD method at a temperature of 200°C or lower, e.g., in the case of using a resin substrate such as one made of a glass-cloth-reinforced epoxy resin as a core substrate. The interlayer insulating film of the inorganic material is preferably formed through a plasma CVD method at a temperature of 400°C or lower, e.g., in the case of using a silicon substrate or glass substrate as a core substrate. In the case of the interlayer insulating films made of a build-up resin used in the related-art multilayer wiring substrate, a thickness of 30µm or more is required due to the demanded insulation characteristic and workability. On the contrary, an interlayer insulating film made of i.e. SiO₂ having a thickness of 1µm provides a withstand voltage of 100V, thus the SiO₂ interlayer insulating films of the exemplary embodiment of the present invention may sufficiently be functional if the thickness thereof is as much as 0.5 to 2µm, for example. In this way, in the multilayer wiring substrate of the exemplary embodiment of the present invention, the interlayer insulating films can be made far thinner than those interlayer insulating films made of a build-up resin in the related-art multilayer wiring substrate. For example, the interlayer insulating films with a thickness smaller than the wiring layer may be provided. In that case, within the multilayer wiring substrate of the present invention, the interlayer insulating films will have surface shapes which strongly reflect the surface shape of the underneath layers, so that the cross-section will have steps as shown in Fig. 1.

As for the interlayer insulating films, inorganic insulating films such as those made of SiO₂, Si₃N₄, SiNO or the like may be used, however SiO₂ is preferable from the standpoint of its withstand voltage and produceability.

The vias 17 of the type which connect adjacent wiring layers, as well as the via 17' of the type which connects upper and lower wiring layers through two or more interlayer insulating films, are formed by filling a wiring material within openings formed in the respective interlayer insulating films 15ab, 15bc, 15cd, 15de. In the case of the related-art multilayer wiring substrate in which the interlayer insulating films are formed of a build-up resin, the openings for vias are formed by laser-processing the interlayer insulating films. On the other hand, in the multilayer wiring substrate of the exemplary embodiment of the present invention, since the interlayer insulating films do not contain heterogeneous materials such as a filler, the formation of the openings for vias within the interlayer insulating films may be performed by a photolithographic method which employs etching. In the case of the laser processing, the diameter of the openings would be 30µm or larger, but with the lithographic method, it is possible to form the openings with a diameter of 10µm or smaller.

In the related-art multilayer wiring substrate in which the interlayer insulating films are formed of a build-up resin, since a single interlayer insulating film is thick, it is difficult to form an opening for a via by simultaneously laser-processing a plurality of the laminated insulating films. Accordingly, a via of the type which connects upper and lower wiring layers through two or more interlayer insulting films is formed by connecting the vias 107'a to 107'd (Fig. 6) individually formed in the respective interlayer insulating films, so that there are the presence of the lands 109 (Fig. 6) at the connecting portions of the respective vias. In the multilayer wiring substrate of the exemplary embodiment of the present invention, a single interlayer insulating film is thin, so that also for the via of the type which connects upper and lower wiring layers through two or more interlayer insulating films, the openings in the respective interlayer insulating films may be formed simultaneously by a lithographic method. Accordingly, in the multilayer wiring substrate of the present invention, the both types of the vias are formed as single via, and the via of the type which connects upper and lower wiring layers through two or more interlayer insulating films has no lands (the members shown by 109 in Fig. 6) at the intermediate portions, which have been inherently present in the type of the via formed by connecting two or more single vias. When the thickness of one interlayer insulating film is increased, the whole thickness of the laminated interlayer insulating films, to which the formation of a via opening is intended, is increased, a thick resist film is required, making it practically difficult to form the via opening at once through dry etching. When dry etching is used for the formation of an opening in SiO₂ insulating films, the selectivity of the SiO₂ insulating films and the resist film with respect to a current etching agent (SF₄ gas) is around four. In the case of the exemplary embodiment of the present invention, a single SiO₂ interlayer insulating film may be approximately 1µm, so that when forming via openings simultaneously within i.e. four layers of the interlayer insulating films, a resist film that is thicker than 16µm may be used.

The present invention will now be further explained with reference to exemplary embodiments thereof, however, it is apparent that the present inv.ention is not limited to these embodiments.

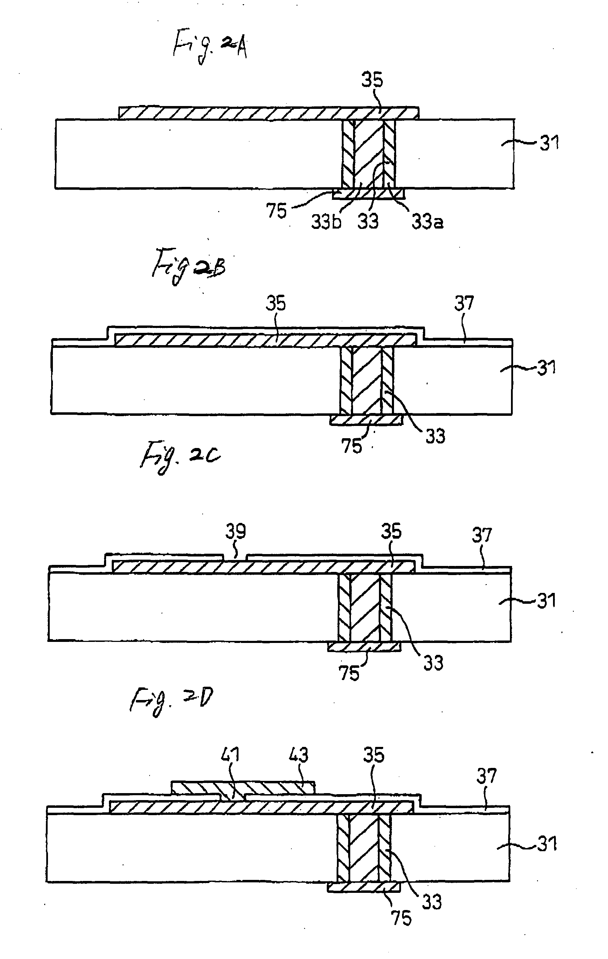

As shown in Fig. 2A, over a core substrate 31 made of a glass-cloth-reinforced epoxy resin having a through hole electrode 33 formed therein, a first wiring layer 35 is formed. The through hole electrode 33 is provided by forming a metal layer 33a on the internal wall of a through hole opened within the core substrate 31, and filling an insulating resin material 33b into the gap within the hole. The wiring layer 35 is provided by forming a resist pattern (not shown) over a seed layer (not shown) on a surface of the core substrate 31, and promoting the growth of a Cu layer to 4µm over an exposed portion of the seed layer by electrolytic plating of Cu. At this point of time, by the method similar to the formation method of the wiring layer 35, a land 75 is formed over the through hole electrode 33 on the back side of the core substrate 31. Thereafter, the resist pattern and the seed layer are eliminated in sequence.

Next, through low-temperature plasma CVD, an SiO₂ interlayer insulating film 37 is formed to a thickness of 1µm over the entire surface, i.e. at 180°C, as shown in Fig. 2B. In this interlayer insulating film 37, an opening 39 (diameter: 10µm) (Fig. 2C) is formed as a via hole connecting between the already-formed first wiring layer 35 and a second wiring layer to be formed next. The formation of the opening 39 is performed by forming a resist pattern (not shown) over the interlayer insulating film 37, and dry-etching a portion of the insulating film 37 which is exposed by an opening in the resist pattern, using CF₄. Thereafter, the resist pattern is eliminated.

Thereafter, a wiring material is filled into the opening 39 to form a via 41 as shown in Fig. 2D, and at the same time, a second wiring layer 43 (4µm thick) is formed over the interlayer insulating film 37. The formation of the via 41 and the wiring layer 43 is performed by first forming a seed layer (not shown) over the surface of the core substrate having the interlayer insulating film 37 formed thereon, then forming a resist pattern (not shown) thereon, and a Cu layer is grown over an exposed portion of the seed layer by electrolytic plating of Cu. Thereafter, the resist pattern and the seed layer are eliminated in sequence.

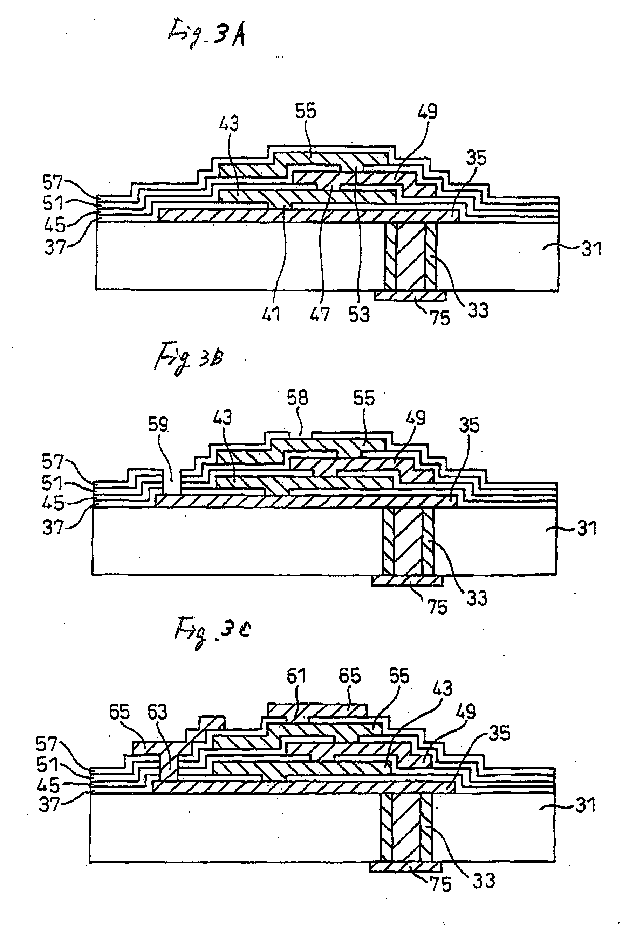

By repeating the steps explained with reference to Figs. 2B through 2D, an interim product is obtained, which has, as shown in Fig. 3A, four wiring layers 35, 43, 49, 55, insulating films 37, 45, 51 between the wiring layers and an insulating film 57 covering the top-most wiring layer 55, and vias 41, 47, 53 interconnecting the adjacent wiring layers. Next, as shown in Fig. 3B, in the top-most insulating film 57 of the interim product, simultaneously are formed: an opening 58 (diameter: 20µm) for a via connecting the fourth wiring layer 55 below and a fifth wiring layer to be formed next; and an opening 59 (diameter: 30µm) for a via connecting the first wiring layer 35 and the fifth wiring layer through the four insulating films 37, 45, 51, 57. The formation of the openings 58 and 59 is performed by the photolithographic method using a CF₄ dry etching in the similar manner as the formation of the openings 39 previously explained. Considering that the selectivity of the SiO₂ insulating film and the resist layer with respect to CF₄ is approximately four, the thickness of the resist layer in this case is approximately 20µm.

The openings 58, 59 are then filled with a wiring material to form vias 61 and 63, and at the same time, the fifth wiring layer 65 (4µm thick) is formed on the interlayer insulating film 57 as shown.in Fig. 3C. The formation of the vias 61, 63 and the wiring layer 65 is performed in a similar manner as the previous formation of the vias and the wiring layers, such as, by first forming a seed layer (not shown) and a resist pattern (not shown) thereon, and growing a Cu layer over an exposed portion of the seed layer by electrolytic plating of Cu. Thereafter, the resist pattern and the seed layer are eliminated in sequence.

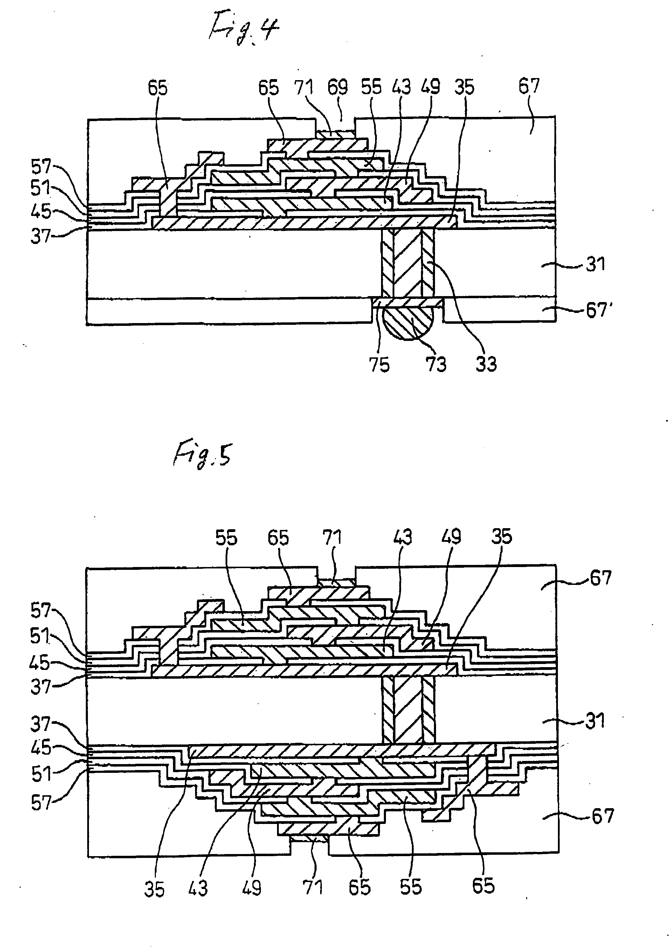

Next, as shown in Fig. 4, protective layers 67, 67' are formed over the entire surfaces of the core substrate 31 having the fifth wiring layer 65 formed thereon, and nickel plating and gold plating are sequentially performed to an opening 69 of the protective layer 67, thereby forming a pad 71 to be used for mounting a semiconductor device or the like (not shown). On the side of the core substrate 31 opposite to the side on which the multilayer wiring structure is formed in this manner, a metal bump 73 may be formed by using, i.e. a solder ball, which is connected to the through hole electrode 33 via the land 75 at an opening in the protective layer 67' which is formed of a solder resist. The one embodiment the multilayer wiring substrate according to the present invention shown in Fig. 4 can be connected to another board (i.e. a circuit board such as a mother board etc.) through the metal bump 73.

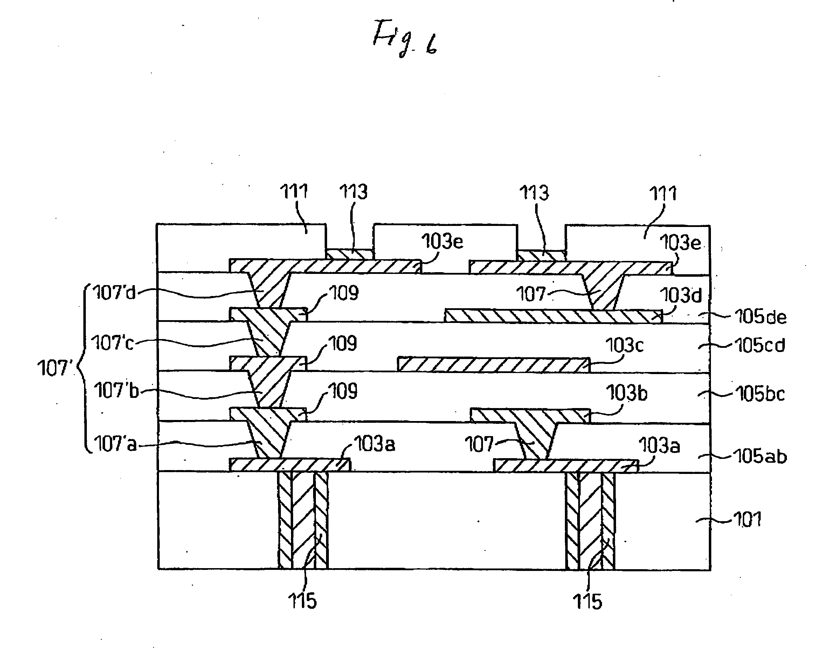

On the side of the core substrate 31 opposite to the side on which the multilayer wiring structure of Fig. 4 is formed, it is also possible to form a similar multilayer wiring structure, and such an embodiment is shown in Fig. 5. In Fig. 5, the upper and lower multilayer wiring structures are similar, and identical members within the upper and lower multilayer wiring structures are designated by the same reference numerals.

In the above embodiments of the present invention, all the interlayer insulating films are formed by SiO₂, however, an embodiment in which some of them are formed by another material is also possible. For example, in the embodiment shown in Fig. 4, if there is only a need to connect the top-most wiring layer 65 to the wiring layer 55 directly below, the insulating film 57 between the wiring layers 55 and 65 may be formed by a typical build-up resin such as an epoxy resin.

## Claims

1. A multilayer wiring substrate comprising:
a plurality of wiring layers (13a-13e; 35, 43, 49, 55, 65) and interlayer insulating films (15ab-15de; 37, 45, 51, 57); and
a via (17', 63) of a type which connects between upper and lower wiring layers through two or more interlayer insulating films,
wherein at least some of said interlayer insulating films (15ab-15de; 37, 45, 51, 57) are formed of inorganic insulating films, and said via of the type which connects between upper and lower wiring layers through two or more interlayer insulating films is formed as a single via which penetrates through the interlayer insulating films all of which are formed of the inorganic insulating films.

2. A multilayer wiring substrate as claimed in Claim 1, wherein all of said interlayer insulating films (15ab-15de; 37, 45, 51, 57) are formed of the inorganic insulating films.

3. A multilayer wiring substrate as claimed in Claim 1 or 2, wherein said inorganic insulating films are formed by a low-temperature CVD method.

4. A multilayer wiring substrate as claimed in any one of Claims 1 trough 3, wherein said inorganic insulating films (15ab-15de; 37, 45, 51, 57) have a thickness between 0.5 and 2.0µm.

5. A manufacturing method of a multilayer wiring substrate having a plurality of wiring layers (13a-13e; 35, 43, 49, 55, 65) and interlayer insulating films (15ab-15de; 37, 45, 51, 57), comprising:
forming two or more interlayer insulating films (15ab-15de; 37, 45, 51, 57) by inorganic material;
forming an opening at once in the two or more interlayer insulating films made of inorganic material by photolithographic method; and
forming a via (17', 63) of the type which connects upper and lower wiring layers trough the two or more interlayer insulating films made of inorganic material by using the opening.

6. A manufacturing method of a multilayer wiring substrate as claimed in Claim 5, wherein said interlayer insulating films (15ab-15de; 37, 45, 51, 57) made of inorganic material are formed by a low-temperature CVD method.
